Europäisches Patentamt

European Patent Office

Office européen des brevets

(19)

(11) Publication number: 0 290 268
A2

# (12) EUROPEAN PATENT APPLICATION

(21) Application number: 88304112.1

(22) Date of filing: 06.05.88

(51) Int. Cl.⁴: H 01 L 21/60
H 01 L 21/285, H 01 L 29/08,
H 01 L 21/82

(30) Priority: 08.05.87 US 47942

(43) Date of publication of application:
09.11.88 Bulletin 88/45

(84) Designated Contracting States: DE FR GB

(71) Applicant: RAYTHEON COMPANY
141 Spring Street
Lexington Massachusetts 02173 (US)

(72) Inventor: Feist, Wolfgang M.
2 Lido Avenue
Burlington Massachusetts 01803 (US)

(74) Representative: Jackson, David Spence et al
REDDIE & GROSE 16, Theobalds Road
London, WC1X 8PL (GB)

(54) Method of forming a bipolar transistor.

(57) A base region (26) is formed in a semiconductor structure and an emitter region (30) is disposed on a surface of a first portion (26″) of the base region (26), the emitter region having upper and side surfaces. An active base region (26″) is formed in the first portion of the base region (26) and an inactive base region (26′) is formed in a second portion of the base region (26). A layer (34) of insulating material is formed over a surface of the inactive base region (26′) and over the upper and side surfaces of the emitter region (30). Portions of such layer are selectively removed to expose the upper surface of the emitter region (30) and a portion of the surface of the inactive base region (26′), and to maintain a region (34a,34b) of insulating material between the exposed surface portion of the inactive base region (26′) and the side surface of the emitter region (30). Silicide contacts (36,38) are formed on the exposed surface portion of the inactive base region (26′) and the exposed upper surface of the emitter region(30), with the insulating material (34a,34b) region insulating such contacts from each other. The spacing between the base and emitter contacts (36,38) is defined by the width of the insulating materials region (34a). A collector region (32) is formed similarly at the same time and has a surrounding region (34c,34d) of insulating material and a silicide contact (40). A silicide contact (44) formed over a p-n junction between a p-type inactive base region (26′) and an n-type epitaxial layer (14) forms a Schottky diode junction (45).

FIG. 8

Description

# METHOD OF FORMING A BIPOLAR TRANSISTOR

Background of the Invention

The present invention relates generally to semiconductor structures and manufacturing methods and more particularly to bipolar integrated circuit transistor structures and manufacturing methods.

As is known in the art, one method of manufacturing bipolar integrated circuit transistors is to provide an epitaxial layer having a first-type (e.g., n-type) conductivity disposed on a silicon substrate having a second, opposite type (e.g., p-type) conductivity. The transistors are formed in the epitaxial layer and adjacent transistors typically are laterally electrically isolated from each other by insulating isolation regions (such as silicon dioxide regions) formed in the epitaxial layer around the transistors. The epitaxial layer provides a collector region for the transistors. A p-type region typically is formed by diffusion in a portion of an upper region of the n-type epitaxial layer. A portion of the p-type region is heavily doped (i.e., $p^+$-type) thereby forming an "inactive" base region, with the surface of the inactive base region forming the base contact of the transistor. A more lightly doped area of the p-type region forms an "active" base region adjacent the inactive base region, over which is deposited an emitter region comprising a suitably doped region of polysilicon. A similar region of suitably doped polysilicon deposited on the surface of the n-type epitaxial layer and spaced from the p-type diffusion region provides the collector contact for the transistor. To reduce the contact resistance of the base, emitter and collector contacts, silicide contacts are typically formed on the base, emitter and collector contacts by depositing a metal layer (such as platinum or palladium) over the structure, alloying the metal with the $p^+$-type base contact and the upper surfaces of the polysilicon emitter region and collector contact, and removing the unreacted metal. Also, a Schottky-clamped transistor may be formed by additionally alloying the deposited metal with the silicon epitaxial layer at the p-n junction between a portion of the $p^+$-type inactive base region and the n-type epitaxial layer. Then, metal electrodes are conventionally formed on the silicide base, emitter, and collector contacts.

As is also known, the performance characteristics of such a bipolar transistor, measured by the power gain thereof at high operating speeds, may be optimized by decreasing the size of the device by as much as possible, specifically by decreasing the size of the base contact and the spacing between such base contact and the emitter contact (i.e., between the "inactive" base region and the emitter region). As such size and spacing are decreased, the contact resistance, parasitic base resistance and parasitic capacitance of the transistor concomitantly decreases, thereby increasing the operating speed and the available power gain of the device at high frequencies. One technique utilized to decrease the spacing between the inactive base and emitter regions, and hence the parasitic base resistance, forms an oxide layer over the epitaxial layer after the formation of the p-type diffusion region therein. A pair of narrow windows (each having a width on the order of one micrometer or less) are etched through the oxide layer, and the emitter region and collector polysilicon contact are deposited through such windows. The portion of the p-type diffusion region disposed beneath the polysilicon emitter region forms the active base region, and the polysilicon emitter region is used as an ion implantation mask for the formation of the more heavily doped inactive base-region adjacent the active base region. Then, a third window is etched in the oxide layer spaced from and adjacent to the polysilicon emitter region and over the inactive base region, and the base contact is formed with such inactive base region by forming a metal silicide contact (for example, using platinum) in the manner discussed above with the inactive base region (at the same time, silicide contacts are made to the emitter region and collector contact and, if desired, a Schottky clamp is formed).

While the above-described manufacturing method has been found satisfactory in some applications, it is often difficult during the manufacturing process to achieve precise registration between the narrow emitter and collector windows and the subsequently applied polysilicon emitter region and collector contact, respectively. As a result, such polysilicon typically overlaps the oxide-layer-windows to ensure the entire openings of such windows are filled with polysilicon. Thus, the base contact window is subsequently formed sufficiently spaced from the emitter region window to avoid the overlapping portions of the polysilicon emitter region. Consequently, the minimum achievable spacing between the emitter and inactive base regions of the transistor is relatively large, on the order of one to two micrometers ( $\mu$m). In some high-speed applications, such spacing may be unacceptably large, since the base-to-emitter resistance increases with increasing spacing between the inactive base and emitter regions. Also, the portions of the polysilicon emitter region overlapping the inactive base region increase the emitter-base capacitance of the transistor. Moreover, the base silicide contact is formed only on the surface of the portion of the inactive base region exposed by the base window, resulting in a less than optimal reduction in the lateral base resistance provided by the silicide contact. Further, the inactive base region is itself relatively wide, due to the relatively large spacing between the base contact and emitter region (to allow for polysilicon overlaps), thereby producing a relatively large base-collector capacitance.

Summary of the Invention

In accordance with the present invention, a method of forming a bipolar transistor in a semiconductor structure is provided comprising the steps of forming a base region in the semiconductor structure and disposing an emitter region on a surface of a first portion of the base region, the emitter region having an upper surface and a side surface. A layer of insulating material is then formed over a surface of a second portion of the base region disposed adjacent to the first portion thereof, and over the upper surface and side surface of the emitter region. Portions of such insulating material layer are selectively removed to expose the upper surface of the emitter region and a portion of the surface of the second portion of the base region, and to maintain a region of the insulating material between the exposed surface portion of the second portion of the base region and the side surface of the emitter region. With such arrangement, the achievable spacing between a contact for the second base region portion and a contact for the emitter region may be substantially reduced, such as to the width of the region of the insulating material, thereby reducing the required size (i.e. width) of the bipolar transistor.

In a preferred embodiment of the present invention, an active base region is formed in the first portion of the base region, over which is disposed the emitter region, with an inactive base region being formed in the second portion of the base region. The layer of insulating material is formed over the surface of the inactive base region and the upper and side surfaces of the emitter region. Portions of the insulating material layer are then selectively removed to expose the upper surface of the emitter region and a portion of the surface of the inactive base region, and to maintain a region of insulating material (i.e. a "sidewall spacer") between the exposed surface of the inactive base region and the side surface of the emitter region. Then, silicide contacts are formed on the exposed surface of the inactive base region and the exposed upper surface of the emitter region, with the sidewall spacer electrically insulating such silicide contacts from each other. Thus, the base and emitter silicide contacts are separated by only the width of a sidewall spacer (such as between 1000 Å and 2500 Å), thereby significantly reducing the base-to-emitter resistance of the transistor. Further, since the emitter region and inactive base region may be formed so closely together, the size (i.e. width) of the inactive base region itself may be reduced. Concomitantly, the base contact (i.e. lateral) resistance and the "up-down" resistance of the inactive base region are reduced due to the decreased size of thereof. Moreover, the base silicide contact may be formed over all of the surface of the inactive base region except for that covered by the sidewall spacer, thereby further lowering the base contact resistance. The smaller inactive base region also reduces the base-collector capacitance of the transistor. Such improvements in the parameters of the bipolar transistor provides increased high frequency power gain and extends the operating frequency of such bipolar transistor.

In accordance with an additional feature of the present invention, a process is provided for fabricating a bipolar transistor having multiple, interdigitated inactive base and emitter regions. A plurality of spaced emitter regions are disposed on a base region, with portions of the base region under the emitter regions forming active base regions and portions of the base region disposed between the emitter regions forming the inactive base regions. A layer of insulating material is deposited over the inactive base regions and a pair of side surfaces and an upper surface of each emitter region. Portions of the insulating material layer are selectively removed to expose the upper surfaces of the emitter regions and portions of the surfaces of the plurality of inactive base regions, and to maintain a pair of insulating material regions abutting the pair of side surfaces of each emitter region. Silicide contacts then are formed on the aforementioned exposed surfaces, with adjacent ones of such silicide contacts being electrically insulated from each other by a region of insulating material.

In accordance with yet another embodiment of the present invention, a method is provided for forming a bipolar transistor and a pair of complementary field effect transistors in a semiconductor structure having a first-type conductivity and a first dopant concentration. A first well of the first-type conductivity and a second dopant concentration is formed in a first region of the semiconductor structure, and a second well having a second-type conductivity, opposite the first-type conductivity, is formed in a second region of the semiconductor structure. A base region having the second-type conductivity is formed for the bipolar transistor in a third region of the semiconductor structure. An emitter region is then disposed on a surface of a first portion of the base region, with a first gate region being disposed over a first portion of the first well and a second gate region being disposed over a first portion of the second well, each one of the emitter region and the first and second gate regions comprising an upper surface and first and second side surfaces. Particles having the first-type conductivity are implanted into: the second gate region; a second portion of the second well adjacent the first portion thereof and the first side surface of the second gate region to form a second source region therein; and a third portion of the second well adjacent the first portion thereof and the second side surface of the second gate region to form a second drain region therein. Then, particles having the second-type conductivity are implanted into: a second portion of the base region adjacent the first portion thereof and the first side surface of the emitter region to form an inactive base region in said second portion of the base region and an active base region in said first portion of the base region; the first gate region; a second portion of the first well adjacent the first portion thereof and the first side surface of the first gate region to form a first source region therein; and a third portion of the first well adjacent the first portion thereof and the second side surface of the first gate region to form a first drain region therein. A layer of insulating material then is formed over the structure and portions thereof are selectively removed to expose portions of the surfaces of the inactive base region, the first source and drain regions, the second source and drain regions and the upper surfaces of the emitter region and first and second gate regions. Such selective removal step maintains: a first region of the insulating material between the exposed surface of the inactive base region and the first side surface of the emitter region; a second region of the insulating material disposed between the exposed surface portion of the first source region and the first side surface of the first gate region; a third region of the insulating material disposed between the exposed portion of the surface of the first drain region and the second side surface of the first gate region; a fourth region of the insulating material disposed between the exposed portion of the surface of the second source region and the first side surface of the second gate region; and a fifth region of the insulating material disposed between the exposed portion of the surface of the second drain region and the second side surface of the second gate region. Then, contacts comprising metal (for example, silicide contacts) are formed on the exposed portions of the surfaces of the inactive base region, the first source and drain regions, the second source and drain regions, and the exposed upper surfaces of the emitter region and first and second gate regions. With such arrangement, bipolar transistors of reduced size may be formed together with complementary MOS transistors on the same substrate to provide a so-called "Bi-CMOS" structure with a minimum of added masking steps.

In accordance with yet another embodiment of the present invention, a method of forming a plurality of doped regions in a semiconductor structure is provided comprising the steps of implanting particles having a first-type conductivity in a first region of the semiconductor structure and implanting particles having a second-type conductivity, opposite to the first-type conductivity, in a second region of the semiconductor structure. A layer comprising silicon nitride is deposited over the first and second regions of the semiconductor structure and the semiconductor structure is heated at a predetermined temperature for a predetermined time selected to drive the first-type conductivity particles to a first predetermined depth in the first region and the second-type conductivity particles to a second predetermined depth in the second region. With such process, the silicon nitride layer is found to substantially prevent the implanted particles from evaporating during the drive cycle (which would decrease dopant concentration) and depositing in other regions of the structure (i.e. "autodoping"), which would contaminate the doping of such other regions. Thus, the first-type conductivity particles can be driven into the first region in the same drive cycle as that used to drive the second-type conductivity particles into the second region, thereby reducing fabrication time.

Brief Description of the Drawings

The foregoing features of the present invention and the advantages thereof may be fully understood from the following detailed description read in conjunction with the accompanying drawings wherein:

FIGS. 1-8 and 10 are cross-sectional elevation views of a bipolar transistor fabricated according to a first embodiment of the present invention at various steps in the manufacture thereof;

FIG. 9 is an isometric view of the bipolar transistor fabricated according to the embodiment illustrated in FIGS. 1-8 and 10 at one step in the manufacture thereof;

FIGS. 11-18 are cross-sectional elevation views of a multi-base, multi-emitter bipolar transistor fabricated according to a second embodiment of the present invention at various steps in the manufacture thereof; and

FIGS. 19-28 are cross-sectional elevation views of a bipolar transistor and CMOS field-effect-transistors fabricated together according to a third embodiment of the present invention at various steps in the manufacture thereof.

Description of the Preferred Embodiments

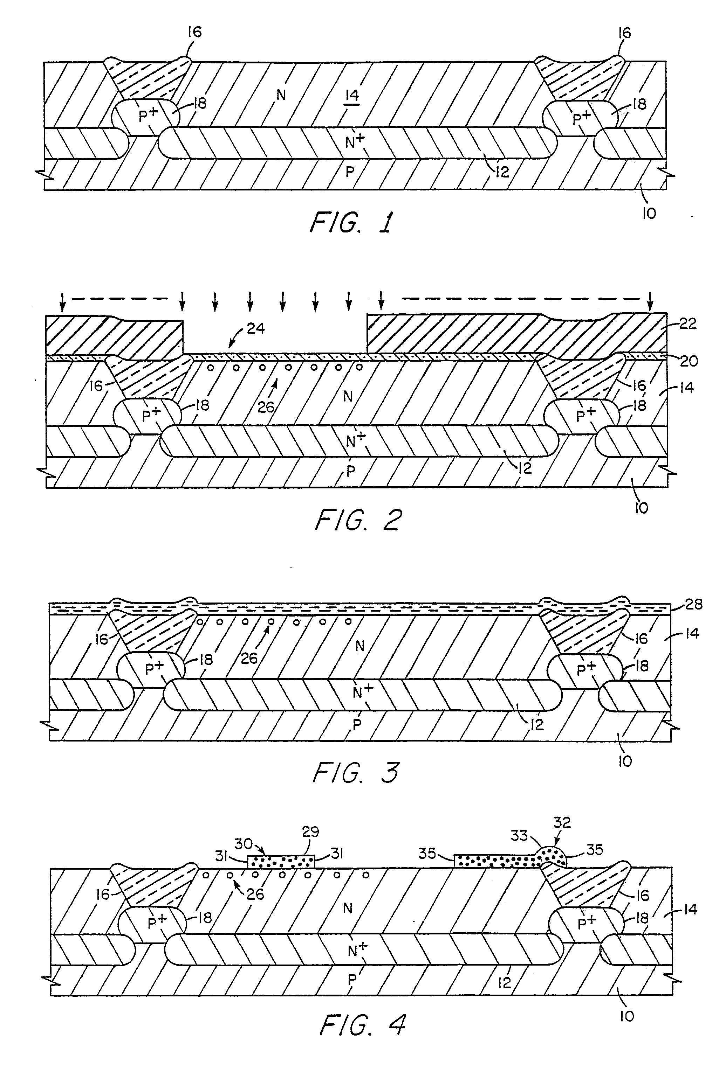

Referring now to FIGS. 1-10, shown are various steps of a process of forming a bipolar transistor device according to a first embodiment of the present invention. Specifically, in FIG. 1, a substrate 10, here comprising p-type conductivity silicon having a surface in the <100> or <111> crystallographic plane and a dopant concentration on the order of $10^{15}$ atoms/cm$^3$, is shown having an n$^+$-type conductivity subcollector region 12 formed therein using any conventional process, here by ion implanting arsenic through a window or windows in a silicon dioxide mask (not shown) followed by an anneal and diffusion step. Alternately, such subcollector region 12 may be formed entirely by diffusion. Here, subcollector 12 is formed to a thickness of approximately 1.5 micrometers ($\mu$m) and with a doping concentration on the order of $10^{20}$ atoms per cm$^3$. After stripping the aforementioned silicon dioxide mask by conventional techniques an epitaxial layer 14 of n-type conductivity silicon is grown. Here such epitaxial layer 14 is grown to a thickness of between 1.5 and 2.0 $\mu$m and has a dopant concentration of between approximately 5 x $10^{15}$/cm$^3$ and 2 x $10^{16}$/cm$^3$. Also disposed in substrate 10 are silicon dioxide (SiO$_2$) field oxide regions 16, each having a thickness of approximately 1 $\mu$m, with p$^+$-type conductivity silicon channel stops 18 disposed beneath field oxide regions 16 to form reverse bias junctions between such channel stops 18 and subcollector region 12 and epitaxial layer 14, as shown in FIG. 1. Thus, reverse bias p-n junction isolation is provided between adjacent devices to be formed in epitaxial layer 14 in a manner to be described. Here, field oxide regions 16 and channel stops 18 are formed in the manner described in U. S. Patent No. 4,569,698, issued to Wolfgang Feist on February 11, 1986, and assigned to the present assignee.

Referring now to FIG. 2, a thin layer 20 of silicon dioxide, here between approximately 150 angstroms (Å) and 250 Å and preferably approximately 200 Å thick, is conventionally grown over the surface of epitaxial layer 14 and a layer 22 of photoresist material is deposited over silicon dioxide layer 20 and field oxide regions 16 as shown. Such photoresist layer 22 is patterned to form window 24 therein, here having a width of between 1.75 μm and 3.0 μm. Then, a suitable p-type conductivity dopant, here boron, is ion implanted in a conventional manner to form a p-type base region 26 in which "active" and "inactive" base regions will subsequently be formed in a manner to be described, such base region 26 here being between 1.75 μm and 3.0 μm wide. Here, such boron ion implantation is performed at a dosage of $1 \times 10^{13}$ per cm$^2$ at 30 Kev. At this point of the process, base region 26 is relatively lightly doped, here having a dopant concentration on the order of $1 \times 10^{18}$ per cm$^3$. The layer 20 of silicon dioxide prevents ion channeling of the implanted boron to allow a shallow p-type region 26, here with a dopant concentration peak at a depth of approximately 1000 Å, to be formed in epitaxial layer 14.

Referring now to FIG. 3, photoresist layer 22 and oxide layer 20 are removed from the structure in a conventional manner, and a layer 28 of polysilicon is deposited over the surface of the structure in a conventional manner, here to a thickness of about 2500 Å. Referring also to FIG. 4, polysilicon layer 28 is here doped with implanted arsenic at a dosage of $5 \times 10^{15}$ to $1 \times 10^{16}$ per cm$^2$ at 160 Kev and a photoresist layer (not shown) is then deposited and patterned to cover only selected regions 30, 32 of polysilicon layer 28 which will become the emitter region and collector contact, respectively, of the bipolar transistor. Such emitter region 30 and collector contact 32 are formed from such polysilicon layer 28 by removing the regions of polysilicon layer 28 exposed by the photoresist in a conventional manner, such as by reactive ion etching or plasma etching. Here, polysilicon emitter region 30 and collector contact 32 each have approximately the same width, between approximately 0.5 μm and 1.0 μm.

It is noted that since base region 26 is formed to a relatively shallow depth (here, with a dopant concentration peak at a depth of about 1000 Å), such reactive ion etching or plasma etching should not etch deeply into base region 26, for example by more than 200 Å, in order to avoid removing a significant amount of the boron dopant and thereby increasing the resistance of the inactive and active base regions to be subsequently formed. Here, excessive etching is avoided in the following manner, it being noted from the outset that the structure depicted in the FIGURES is typically located in a silicon wafer of suitable size, such as a few inches in diameter, containing many similar structures. Thus, a little thought reveals that a major portion of the surface area of such wafer beneath polysilicon layer 28 is covered with the insulating material (here, silicon dioxide) of field oxide regions 16. Reactive ion etching, here performed using a Model 61 Reactive Ion Etcher manufactured by Metals Research Corporation, slightly nonuniformly etches the wafer, here from the edges to the center thereof. It has been found that as polysilicon layer 28, which is somewhat transparent, is removed from the surface of the wafer by the reactive ion etching process, concentric color fringes develop on the wafer, which move radially from the edges to the center of the wafer. The color stops changing in a given region when all of the polysilicon has been removed from the silicon dioxide in that region (i.e., when the silicon dioxide is exposed). Thus, during etching, the color of the wafer visibly changes, beginning at the edges thereof, such color change proceeding from the wafer edges to the center of the wafer. Then, the wafer will stop changing color, beginning at the edges of the wafer and proceeding to the center thereof. Thus, by observing the center of the wafer during reactive ion etching, the color thereof will begin to change when etching of the polysilicon at the center of the wafer starts. As soon as the center of the wafer is observed to stop changing color, the reactive ion etching process is halted. Thus, any etching into base regions 26 of transistor structures located at or near the center of the wafer is substantially prevented. It is noted that some etching into base regions 26 will occur in transistor structures located at or near the edges of the wafer, since etching proceeds from the wafer edges to the center thereof. However, the reactive ion etching process is sufficiently uniform, and the size of the wafer is sufficiently small, so that the desired less than 200 Å will be removed from base regions 26 of such wafer-edge-disposed transistor structures. It is noted that the above-discussed color change may alternately be detected with an optical sensor which would produce a control signal to halt the reactive ion etching process when the sensor detects that the center of the wafer has stopped changing color, thereby enabling the reactive ion etching process to be automated while still avoiding etching deeper than the specified 200 Å into base region 26.

After the above-discussed etching process is completed, the photoresist layer (not shown in FIG. 4) disposed over polysilicon regions 30, 32 is removed by any conventional process. Thus, an emitter region 30 of n-doped polysilicon and an n-doped polysilicon collector electrode contact 32, each here having a width of between 0.5 μm and 1.0 μm, remain on the surface of the structure. It is here noted that emitter region 30 lies completely over base region 26 and, here, collector contact 32 lies partially over epitaxial layer 14 and partially over field oxide region 16 to facilitate electrical connection thereto. It is also noted that emitter region comprises an upper surface 29 and side surfaces 31, as shown in FIG. 4. Likewise, collector contact 32 includes an upper surface 33 and side surfaces 35.

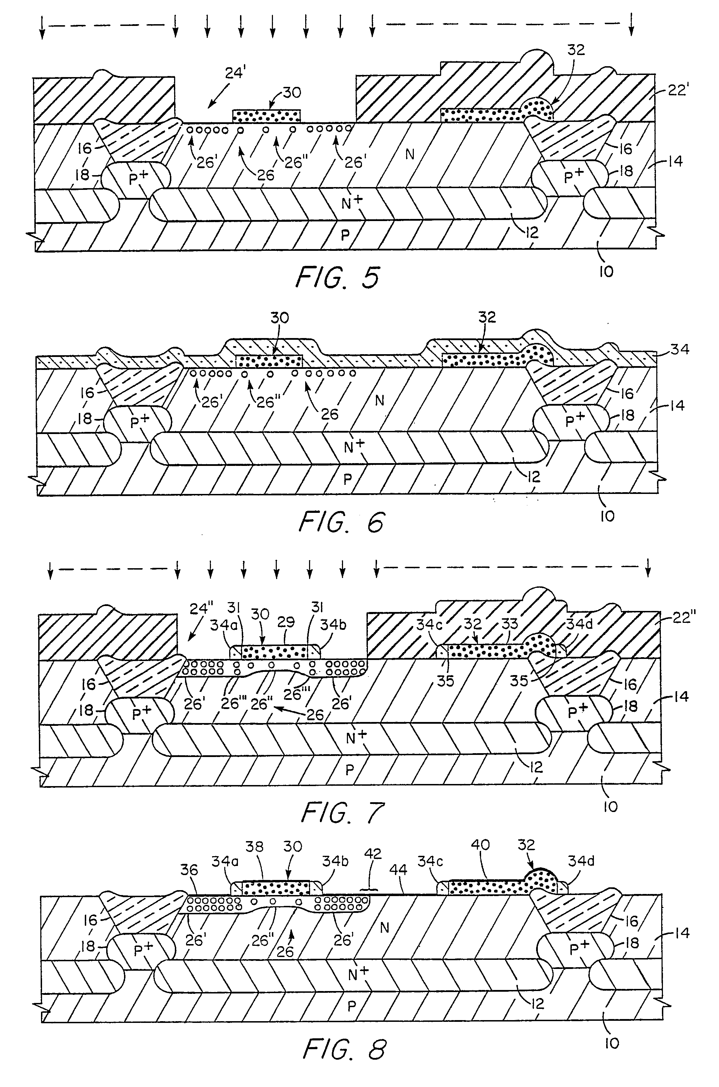

Referring now to FIG. 5, photoresist layer 22' is applied over the structure and patterned to form a window 24' therein exposing doped base region 26 and polysilicon emitter region 30, as shown. It is noted that the surfaces of first portion 26' of base region 26 is exposed by polysilicon emitter region 30, with such emitter region 30 providing a mask over a surface of a second portion 26" of base region 26. Additional p-type dopant (here boron) is implanted into the first portions 26' of base region 26 unmasked by emitter region 30 to thereby form "inactive" base regions 26', such inactive base region 26' having decreased contact resistance due to such additionally implanted boron. It is noted that polysilicon emitter region 30 acts as a mask to substantially prevent the implanted boron from reaching second portion 26″ of base region 26, thereby forming an "active" base region 26″ having a lower doping concentration, and hence higher contact resistance, than inactive base regions 26′. A little thought reveals that active base region 26″ has substantially the same width (here between 0.5 μm and 1.0 μm) as emitter region 30. Here the ion implantation of boron is accomplished with dosage of approximately $5 \times 10^{13}$ per $cm^2$ at 30 Kev. At this point in the process, the dopant concentration of inactive base regions 26′ is on the order of $5 \times 10^{18}$ per $cm^3$. Here, the inactive base region 26′ disposed to the left of emitter region 30 in the FIGURES is between 0.75 μm and 1.25 μm wide, while that of the inactive base region 26′ shown disposed to the right of emitter region 30 is between 0.5 μm and 0.75 μm. Photoresist layer 22′ is then removed by any conventional process.

Referring now to FIG. 6, a layer 34 of insulating material (here silicon dioxide) is applied over the surface of the structure, here to a thickness of between approxi mately 1500 Å and 3000 Å and preferably 2000 Å. Here, such insulating layer 34 is applied by chemical vapor deposition, using $SiH_4$ and $O_2$ at 425° C. The silicon dioxide layer 34 is then anisotropically etched away from the horizontal surfaces thereof; that is, silicon dioxide layer 34 is vertically etched. Here, such anisotropic etching is performed using $CHF_3$, commercially available as Freon 13Ⓔ. Referring also to FIG. 7, such vertical or anisotropic etching exposes a portion of the surface of inactive base regions 26′ and epitaxial layer 14 and also the upper surfaces 29, 33 (FIG. 4) of emitter region 30 and collector contact 32, respectively. The etching also forms sidewall spacer regions 34a, 34b of insulating material abutting side surfaces 31 of polysilicon emitter region 30 and sidewall spacer regions 34c, 34d of insulating material abutting side surfaces 35 of of polysilicon collector contact 32. Sidewall spacer regions 34a-34d here each have a width of between 1000 Å and 2500 Å.

Here, photoresist layer 22″ is subsequently deposited over the structure and patterned to form a window 24″ therein, exposing base region 26, polysilicon emitter region 30 and insulating spacers 34a, 34b, as shown. It is noted that polysilicon emitter region 30 and abutting insulating spacers 34a, 34b provide a mask over active base region 26″ (disposed below emitter region 30) and those portions 26‴ of inactive base regions 26′ disposed beneath insulating spacers 34a, 34b. An additional level of boron here is implanted into the portions of inactive base regions 26′ unmasked by emitter region 30 and spacers 34a, 34b to further reduce the contact resistance of such unmasked portions of inactive base regions 26′. Here, such ion implantation step is at a dosage not exceeding $5 \times 10^{14}$ per $cm^2$ at about 30 Kev to provide a dopant concentration on the order of $5 \times 10^{19}$ per $cm^3$ in such unmasked portions of inactive base regions 26′. It is noted that such dosage may be increased to increase the dopant concentration in inactive base region 26′; however, in such case photoresist layer 22″ should alternately be patterned to additionally mask emitter region 30 to prevent undesired excessive compensation of the arsenic dopant in emitter region 30 by the implanted boron. Then, photoresist layer 22″ is removed in any conventional manner. The structure is then heated, here to about 950° centigrade for approximately 20 to 30 minutes, to diffuse the implanted arsenic in the emitter polysilicon region 30 downward through such polysilicon region and somewhat into the active base region 26″, to anneal out crystal imperfections in active base region 26″, and to activate the dopant. The heating process is halted when the optimum transistor gain is reached. It has been found that spacers 34a, 34b substantially prevent the implanted arsenic in emitter region 30 from outdiffusing into inactive base regions 26′, which would increase the contact resistance of inactive base regions 26′ by decreasing the net p-type dopant concentration therein.

It is noted that the ion implantation step associated with FIG. 7 is performed after spacer regions 34a, 34b have been formed abutting sides 31 of emitter contact 30. A little thought thus reveals that here base region 26 has three regions having three different dopant concentrations at the conclusion of the ion implantation step of FIG. 7: (1) inactive base regions 26′ having a relatively heavy dopant concentration (on the order of $5 \times 10^{19}$ per $cm^3$); (2) active base region 26″ having a relatively light dopant concentration (on the order of $1 \times 10^{18}$ per $cm^3$); and (3) regions 26‴ of inactive base regions 26′ disposed beneath spacers 34a, 34b and having a doping concentration between that of the remainder of inactive base regions 26′ and active base region 26″ (on the order of $5 \times 10^{18}$ per $cm^3$). Thus, each region 26‴ provides a transition region (having a width approximately equal to that of a sidewall spacer 34a, 34b) between the relatively heavy doping concentration of inactive base regions 26′ and the more lightly doped active base region 26″ to thereby maintain a relatively high reverse breakdown voltage between the base and emitter, here between 4 and 7 volts. It is noted that the additional ion implantation step of FIG. 7 also decreases the contact resistance, that is the lateral resistance, of the inactive base region 26′ (and hence reduces the electrical resistance between the base and emitter of the transistor device), and additionally reduces the epidermal (or "up-down") resistance of the inactive base regions 26′ by a factor of 3 to 5.

Referring now to FIG. 8, a metal layer, here titanium (although other metals such as cobalt, platinum or palladium may alternately be employed), is next deposited over the entire surface of the structure and the structure is heated in a conventional manner to produce an alloying reaction between the deposited titanium and exposed silicon surfaces (such as the surfaces of inactive base regions 26′ not covered by spacers 34a, 34b, upper surfaces 29, 33 of emitter region 30 and collector contact 32, respectively, and the surface of epitaxial layer 14 therebetween), forming metal silicide contacts on such exposed silicon surfaces. As is known, such metal will not so react with silicon dioxide (i.e.,

sidewall spacers 34a-34d and field oxide regions 16). The unreacted metal is removed in any conventional manner (here using hydrogen peroxide to remove unreacted titanium) to thereby form self-aligned silicide contacts 36, 38, 40 on the surface of a portion of inactive base region 26', upper surface 29 of emitter region 30 and upper surface 33 of collector contact 32, respectively, of the bipolar transistor device, as shown. As is known, the formation of silicide on the base, emitter and collector contact surfaces of the bipolar transistor substantially reduces the vertical and lateral resistance of such contacts. As also shown in FIG. 8, here an additional silicide layer 44 is formed on the surface of epitaxial layer 14 and inactive base region 26' between emitter region 30 and collector contact 32, and hence over a junction region 42 formed between such portion of the p-type conductivity inactive base region 26' and the n-type conductivity epitaxial layer 14 at the surface of the structure. That is, silicide layer 44 is formed over the p-n junction formed between the p-type inactive base region 26' and the n-type epitaxial layer 14, thereby forming a Schottky diode junction therebetween. Thus, the bipolar transistor is seen to be "Schottky clamped" between the base region and the collector region thereof. It is noted that if such Schottky diode is not desirable in a given application, the formation thereof may be prevented by disposing a photoresist mask (not shown) over that portion of silicon dioxide layer 34 (FIG. 6) which overlies the surface junction 42 (FIG. 8) between p+-type conductivity inactive base region 26' and n-type epitaxial layer 14. Thus, a portion of silicon dioxide layer 34 will remain over junction 42 after the anisotropic etching of insulating layer 34, thereby preventing formation of silicide over junction 42.

Silicon dioxide sidewall spacers 34a-34d provide electrical isolation between adjacently disposed silicide contacts 36, 38, 40, 44. That is, insulating spacer 34a provides electrical isolation between base silicide contact 36 and emitter silicide contact 38. Likewise, sidewall spacer 34b insulates emitter silicide contact 38 from Schottky silicide layer 44. Further, silicon dioxide spacer 34c' prevents Schottky silicide contact 44 from short-circuiting with collector silicide contact 40.

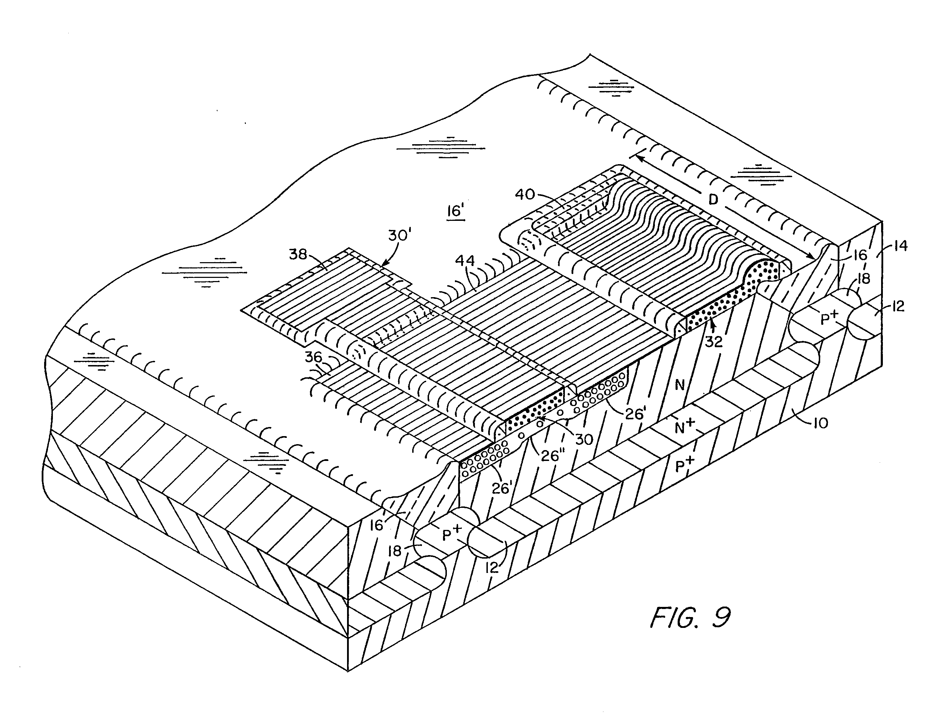

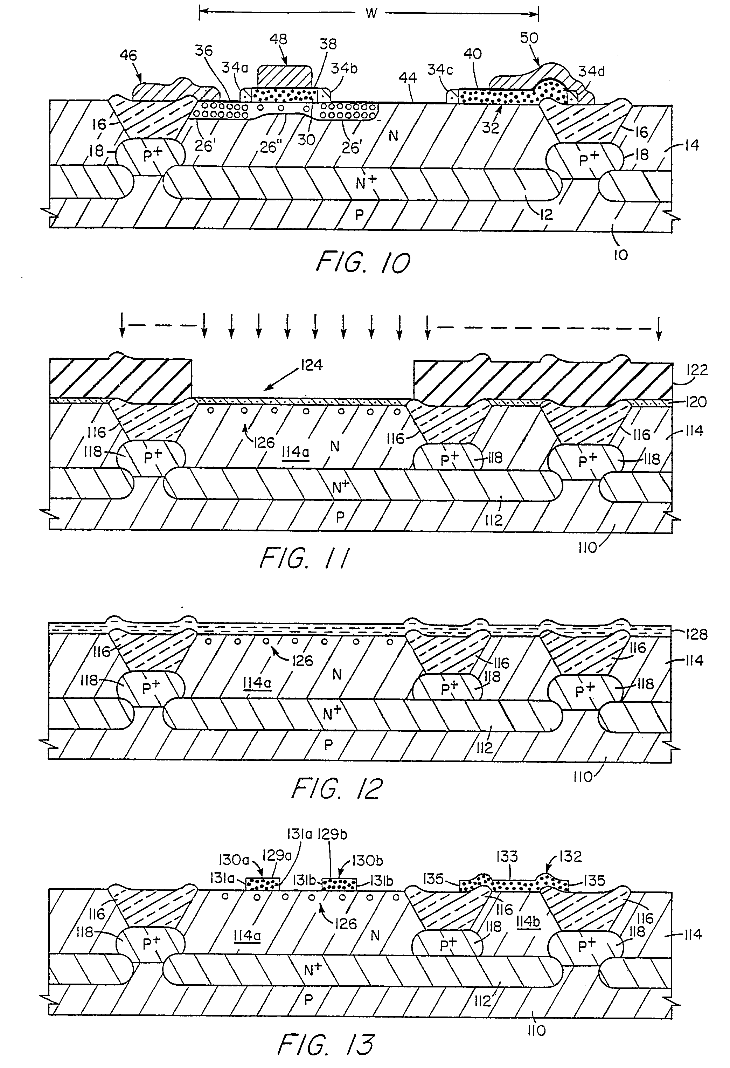

Referring now to FIG. 9, an isometric view of the structure of FIG. 8 is shown. Here, collector contact 32 and silicide contacts 36, 40, 44 have a depth D of approximately 3 μm. Here, emitter region 30 comprises an extended and enlarged region 30', over which silicide contact 38 is also deposited, to facilitate connection to emitter region 30 with an electrode. Here, the extended and enlarged region 30' of emitter region 30 is disposed over field oxide region 16' running perpendicularly between field oxide regions 16, as shown. Referring also to FIG. 10, metal electrodes 46, 48, 50, here comprising TiW and aluminum or titanium and gold, are deposited on the structure using conventional photolithographic techniques to form the base, emitter and collector electrodes, respectively, of the bipolar transistor. Alternately, such electrodes 46, 48, 50 may be deposited by conventional selective chemical vapor deposition of tungsten. It is noted that the base and collector electrodes 46, 50 may be deposited in the device area or additionally over the field oxide regions 16 to facilitate alignment of such electrodes 46, 50 with inactive base region 26' and collector contact 32, respectively. Also, emitter electrode 48 may be deposited in the device area or on polysilicon extension 30' (FIG. 9).

With the above-described process of the present invention the overall width, W (FIG. 10), of the bipolar transistor may be substantially reduced, such as to 5 μm or less, from that obtainable by conventional methods (on the order of 8 to 10 μm) due to the use of insulating sidewall spacers 34a-34d to provide electrical isolation between base, emitter and collector silicide contacts 36, 38, 40 and Schottky silicide contact 44. Particularly, the spacing between base silicide contact 36 and emitter silicide contact 38 may be reduced to between 0.1 μm (1000 Å) and 0.25 μm (2500 Å), the width of sidewall spacer 34a, thereby lowering the transistor's base-to-emitter resistance. The reduced transistor width results in a smaller inactive base region 26' over which base electrode 46 is disposed, thereby reducing the contact or lateral resistance thereof as well as the "up-down" resistance thereof. Further, such smaller inactive base region reduces the base-to-collector capacitance of the bipolar transistor. Therefore, the transistor's high-frequency power gain and operating speed are increased.

Referring now to FIGS. 11-18, shown is a second embodiment of the process of the present invention, in which a bipolar transistor having interdigitated multiple base and emitter regions is formed. FIG. 11 depicts the structure in the same stage of production as that of FIG. 2 of the first embodiment, although it is noted that an additional field oxide region 116 and p+-type channel stop 118 are shown for purposes to be described. Here, the thicknesses, conductivity types and dopant concentrations of p-type substrate 110, n+-type buried layer 112 and n-type epitaxial layer 114 are substantially the same as in the embodiment of FIGS. 1-9. As shown in FIG. 11, photoresist layer 122 is deposited over the structure and patterned to form a window 124 therein exposing an area 114a of epitaxial layer 114 and a thin oxide layer 120 (here, between 150 Å and 250 Å and preferably 200 Å thick) previously formed over epitaxial layer 114. Then, a suitable p-type conductivity dopant (here boron) is ion implanted (here at a dosage of 1 x 10^13 per cm^2 at 30 KeV) to form a p-type base region 126, as shown. Referring to FIG. 12, after photoresist layer 122 and thin oxide layer 120 are removed, a layer 128 of polysilicon is deposited, here to a thickness of approximately 2500 Å, and then is suitably doped, here with arsenic implanted at a dosage of between 5 x 10^15 and 1 x 10^16 per cm^2 at 150 KeV. Referring to FIG. 13, a photoresist layer (not shown) is deposited over the structure and patterned to cover a plurality, here two, of regions 130a, 130b of polysilicon layer 128 disposed over base region 126 and a region 132 of polysilicon layer 128 disposed over an area 114b of epitaxial layer 114 separated from epitaxial layer area 114a by a field oxide region 116 and channel stop 118, as shown, but electrically coupled thereto by subcollector region 112. The remainder of polysilicon layer 128 is etched away (here by reactive ion etching) to form a plurality (here two) of polysilicon emitter regions 130a, 130b and a polysilicon collector contact 132. It is noted that such reactive ion etching should not cut more than 200 Å into base region 126, and the procedure described above for so limiting the depth of the reactive ion etch is equally applicable here. Then, the previously deposited photoresist (not shown) is removed. As shown, emitter region 130a comprises upper surface 129a and side surfaces 131a. Likewise, emitter region 130b includes upper surface 129b and side surfaces 131b. Similarly, collector contact 132 includes upper surface 133 and side surfaces 135.

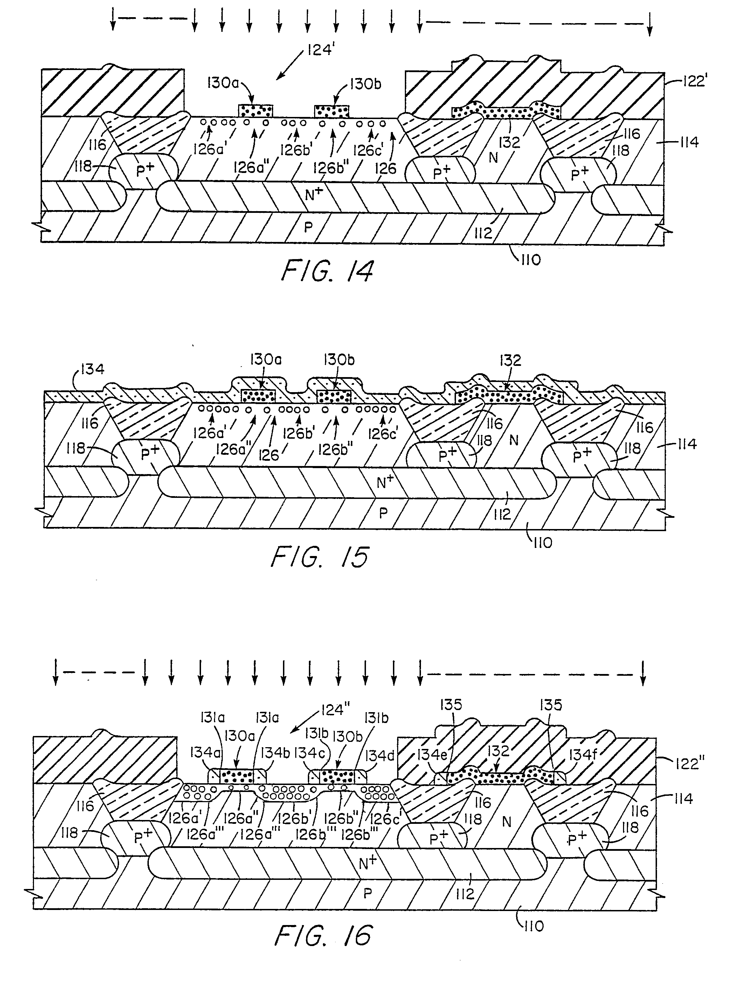

Referring next to FIG. 14, photoresist layer 122′ is deposited and window 124′ formed therein exposing base region 126 and emitter regions 130a, 130b. It is noted that first portions 126a′, 126b′, 126c′ of base region 126 are exposed by window 124′ and second portions 126a″, 126b″ of base region 126 are masked by polysilicon emitter regions 130a, 130b. Additional boron is then ion implanted (here at $5 \times 10^{13}$ per cm$^2$, 30 KeV) to increase the p-type dopant concentration of first portions 126a′, 126b′, 126c′. Thus, first portions 126a′, 126b′, 126c′ become the inactive base regions of the transistor and second portions 126a″, 126b″ become the active base regions thereof.

Referring to FIG. 15, an insulating layer 134 of, here, silicon dioxide is conventionally applied over the structure, here to a thickness of between approximately 2000 Å and 3000 Å and preferably 2000 Å. Such insulating layer 134 is then anisotropically etched away from horizontal surfaces (i.e., vertically etched) in the manner described above, thereby exposing the upper surfaces of emitter regions 130a, 130b and collector contact 132, and also exposing portions of the surfaces of inactive base regions 126a′, 126b′, 126c′. Such etching also forms insulating sidewall spacers 134a-134f abutting the sides of polysilicon emitter regions 130a, 130b and polysilicon collector contact 132, respectively, as shown in FIG. 16. That is, insulating spacers 134a, 134b abut side surfaces 131a of emitter region 130a, insulating spacers 134c, 134d abut side surfaces 131b of emitter region 130b, and spacers 134e, 134f abut side surfaces 135 of collector contact 132. Here, each insulating spacer is between 1000 Å and 2500 Å wide.

If desired, a third photoresist layer 122″ may be deposited and patterned to form window 124″, as shown in FIG. 16, and additional boron ion implanted (here at a dosage of up to $5 \times 10^{14}$ per cm$^2$, 30 KeV) through window 124″ and into the portions of inactive base regions 126a′, 126b′, 126c′ exposed by emitter regions 130a, 130b and sidewall spacers 134a-134d to further reduce the contact resistance thereof. As discussed, if a greater dosage is desired, photoresist layer 122″ should also mask emitter regions 130a, 130b to prevent excessive compensation of the arsenic dopant therein by the implanted boron. It is noted that polysilicon emitter contacts 130a, 130b and abutting silicon dioxide spacers 134a-134d provide masks over active base regions 126a″, 126b″ and those portions of inactive base regions 126a′, 126b′, 126c′ disposed below sidwalls 134a-134d. Thus, dopant transition regions 126a‴, 126b‴ are formed beneath such sidewalls between the rather heavily doped inactive base regions 126a′, 126b′, 126c′ and the more lightly doped active base regions 126a″, 126b″, such transition regions having a dopant concentration between that of the inactive and active base regions. As discussed, such arrangement increases the base-emitter reverse breakdown voltage. Then, photoresist layer 122″ is removed by any conventional method. The structure is then heated (here at 950°C for 20-30 minutes) to diffuse the implanted arsenic in regions 130a, 130b through the polysilicon thereof and somewhat into active base regions 126a″, 126b″, to anneal such base regions 126a″, 126b″ and to activate the dopant.

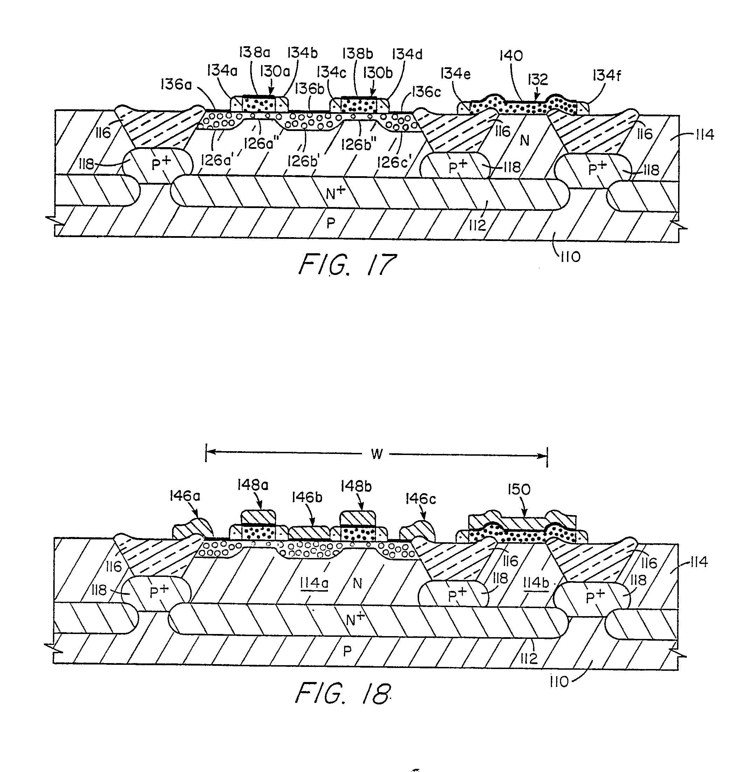

Referring now to FIG. 17, a metal layer, here titanium, is applied over the entire surface of the structure, and the structure heated sufficiently to produce an alloying reaction between the titanium and silicon surfaces. Thus, base silicide contacts 136a, 136b, 136c are formed on the surfaces of inactive base regions 126a′, 126b′, 126c′, respectively. Further, emitter silicide contacts 138a, 138b are formed on the surfaces of polysilicon emitter regions 130a, 130b. Likewise, collector silicide contact 140 is formed on the surface of polysilicon collector contact 132. As discussed, the deposited metal does not react with insulating material (such as silicon dioxide spacers 134a-134f and field oxide regions 116). Thus, after such unreacted titanium is removed (here using hydrogen peroxide), silicide contacts 136a, 138a, 136b, 138b, 136c, 140 are electrically isolated from each other by sidewalls 134a-134f. Referring to FIG. 18, metal electrode connections 146a, 146b, 146c, 148a, 148b, 150 (here comprising TiW) are made with silicide contacts 136a, 136b, 136c, 138a, 138b, 140, respectively, as shown. Thus, the transistor structure illustrated in FIG. 18 comprises three base electrodes 146a, 146b, 146c, two emitter electrodes 148a, 148b, and a collector electrode 150.

Referring again to FIG. 17 it is noted that base silicide contacts 136a, 136b, 136c are self-aligned and closely spaced from self-aligned emitter silicide contacts 138a, 138b by respective insulating spacers 134a-134d. That is, adjacent ones of such silicide contacts are separated by only the width (here, between 1000 Å and 2500 Å) of a spacer. Thus, as discussed in detail above, the overall width W (FIG. 18) of the transistor is reduced, as is the base-to-emitter resistance thereof, due to the close spacing between such base silicide contacts (136a, 136b, 136c) and emitter silicide contacts (138a, 138b). The interdigitated multiple-base, multiple-emitter bipolar transistor thus formed has increased power capability over single-base, single-emitter transistors, and improved high frequency power gain over conventional multiple-emitter transistors due to the reduced base-to-emitter resistance thereof. The collector contact here is made between n-type epitaxial layer areas 114a, 114b via n+-type buried subcollector 112. If desired, the portion of epitaxial layer 114 disposed beneath collector contact 132 may be doped with added n-type conductivity dopant (e.g., ion implanted phosphorous) to decrease the collector resistance of the transistor.

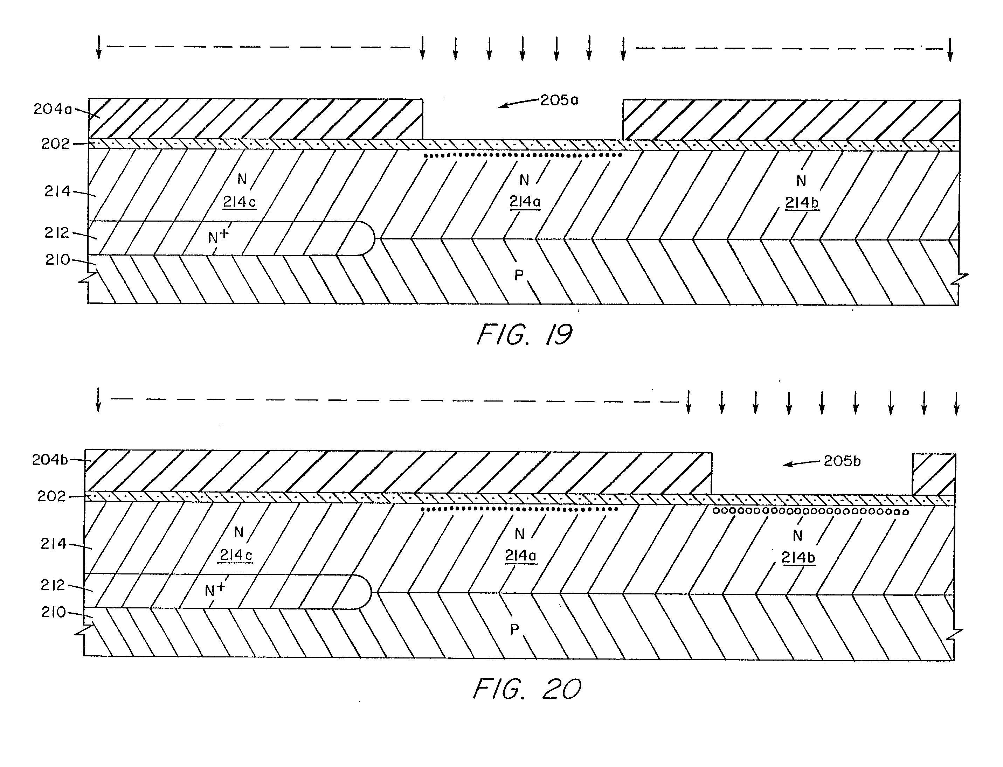

In still another embodiment of the present invention, shown in FIGS. 19-27, bipolar transistors of reduced size (as discussed above) may be formed together with complementary metal oxide semiconductor (CMOS) field effect transistors on the same substrate to provide a so-called "Bi-CMOS" structure. Referring to FIG. 19, a substrate 210, here comprising p-type conductivity silicon with a surface in the <100> or <111> crystallographic plane, is here provided having a dopant concentration on the order of $10^{15}$ atoms per $cm^2$. Here, an $n^+$-type conductivity subcollector region 212 is formed in a conventional manner only in those areas of substrate 210 over which will be formed bipolar transistors, although subcollector region 212 may also be formed in areas of substrate 210 which will support n-wells for CMOS transistors to be subsequently fabricated as described hereinafter. Subcollector region 212 here is formed with a thickness of about 1.5 $\mu$m and a doping concentration on the order of $10^{20}$ atoms per $cm^3$. Next, epitaxial layer 214 of n-type conductivity silicon is grown over substrate 210, here to a thickness of approximately 1.5 $\mu$m to 2.0 $\mu$m with a dopant concentration between approximately 5 x $10^{15}/cm^3$ and 2 x $10^{16}/cm^3$.

Here, it is desirable to provide the epitaxial layer n-wells and p-wells of the CMOS transistors with doping concentrations on the order of $10^{17}/cm^3$, while optimum dopant concentration for epitaxial layer 214 in the areas of the bipolar transistors is somewhat less, here a maximum about 2 x $10^{16}/cm^3$. Thus, in accordance with an additional feature of the present invention, Applicant provides a process for driving implanted dopant (i.e. impurities) to a predetermined depth in an area of epitaxial layer 214 while substantially preventing loss of dopant therefrom by evaporation and contamination of adjacent areas of epitaxial layer 214 by such evaporated dopant. Here, additional impurities are implanted into areas 214a, 214b of epitaxial layer 214 wherein n-wells and p-wells, respectively, for the CMOS transistors will be formed, while areas of epitaxial layer 214 wherein bipolar transistors will be formed are shielded from such additional dopant implantation. Insulating layer 202, here comprising silicon dioxide ($SiO_2$), is grown on the surface of the structure to a thickness of about 1200 Å in a conventional manner, here by heating the structure at about 1000°C for about 12 minutes in a steam atmosphere. Then, layer 204a of photoresist material is deposited over $SiO_2$ layer 202 and patterned to form a window 205a therein, thereby exposing an area 214a of epitaxial layer 214 in which a CMOS n-well will be formed. It is noted that layer 204a masks areas 214b, 214c of epitaxial layer 214. Next, a suitable n-type conductivity dopant, here phosphorus, is ion implanted through window 205a and $SiO_2$ layer 202 into epitaxial layer area 214a, here at a dosage of 1.3 x $10^{14}/cm^2$ at 200 Kev. Referring now to FIG. 20, photoresist layer 204a is conventionally removed and a second layer 204b of photoresist is deposited over $SiO_2$ layer 202 and patterned to form window 205b therein exposing an area 214b of epitaxial layer 214 in which a CMOS p-well will be formed. It is noted that photoresist layer 204b masks both epitaxial layer areas 214a, 214c. Then, a suitable p-type conductivity dopant, here boron, is ion implanted (here at a dosage of 2.5 x $10^{13}/cm^2$ at 200 Kev) through window 205a into epitaxial layer area 214b. Thus, it is noted that the dopant concentration of epitaxial layer areas 214a, 214b (which will become CMOS n- and p-wells, respectively) are increased, while that of epitaxial layer area 214c, which will become a bipolar transistor collector region, remains unchanged.

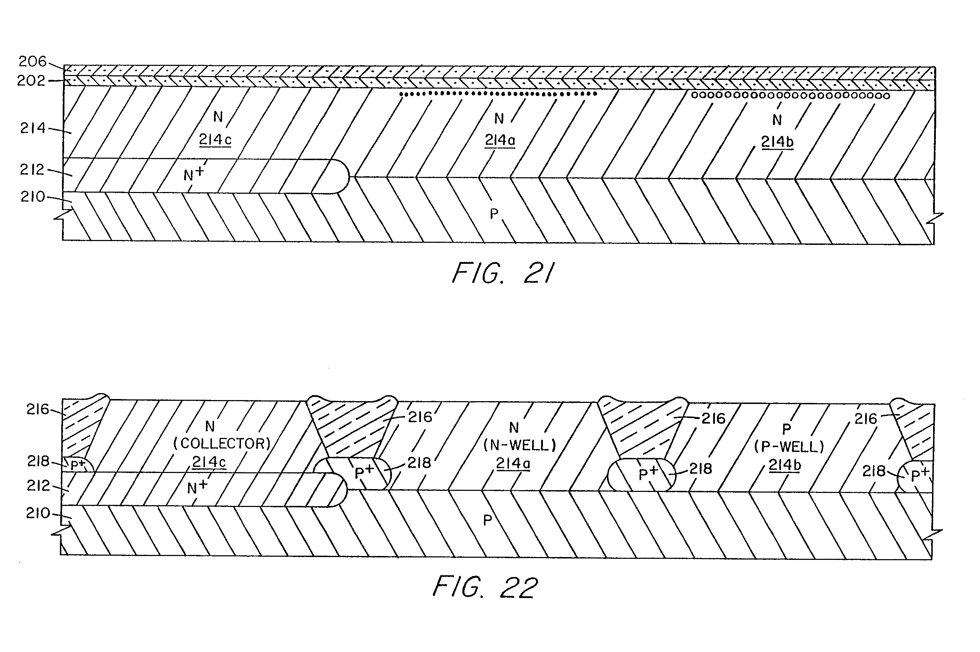

Referring now to FIG. 21, photoresist layer 204b is removed and a layer 206 of silicon nitride ($Si_3N_4$) is deposited over $SiO_2$ layer 202 at a temperature of about 800°C to a thickness between approximately 500 Å and 1500 Å, and here preferably to a thickness of about 1500 Å. The thickness of layer 206 in a given application will depend on the concentration of the dopant to be driven through the semiconductor layer and the duration of the drive cycle. However, the $Si_3N_4$ expands at a different rate than the silicon of epitaxial layer 214 during the drive cycle. Thus, if layer 206 is made too thick, such $Si_3N_4$ layer 206 will crack. After deposition of $Si_3N_4$ layer 206, the structure is heated (here, in nitrogen at between 800°C and 1200°C, preferably about 900°C, for approximately 20 minutes) to anneal the silicon. Next, the structure is further heated at an increased temperature, here within the range from 900°C to 1200°C and preferably at approximately 1100°C for a predetermined time, here between 6 hours and 10 hours and preferably about 6.5 hours, to drive the n- and p-type dopant in epitaxial layer areas 214a, 214b, respectively, downward through such epitaxial layer areas 214a, 214b to distribute such dopant therein. Here, the temperature and time duration of the above-described drive cycle is selected to drive the n-type and p-type dopant to a depth of approximately 2 $\mu$m in epitaxial layer areas 214a, 214b, respectively. It is noted that the n-type dopant in epitaxial layer area 214a and the p-type dopant in epitaxial layer 214b are driven downward simultaneously, rather than in separate drive cycles as is conventional. Applicant has found that $Si_3N_4$ layer 206 seals (i.e., provides a "cap" over) epitaxial layer areas 214a, 214b to substantially prevent the loss by evaporation of n-type and p-type dopants, respectively, therefrom by evaporation during the single dopant drive cycle. Thus, unwanted transfer of dopant (i.e., "autodoping") between epitaxial layer areas 214a, 214b and between epitaxial layer areas 214a, 214b and other areas of epitaxial layer 214 (such as bipolar transistor area 214c) is substantially prevented.

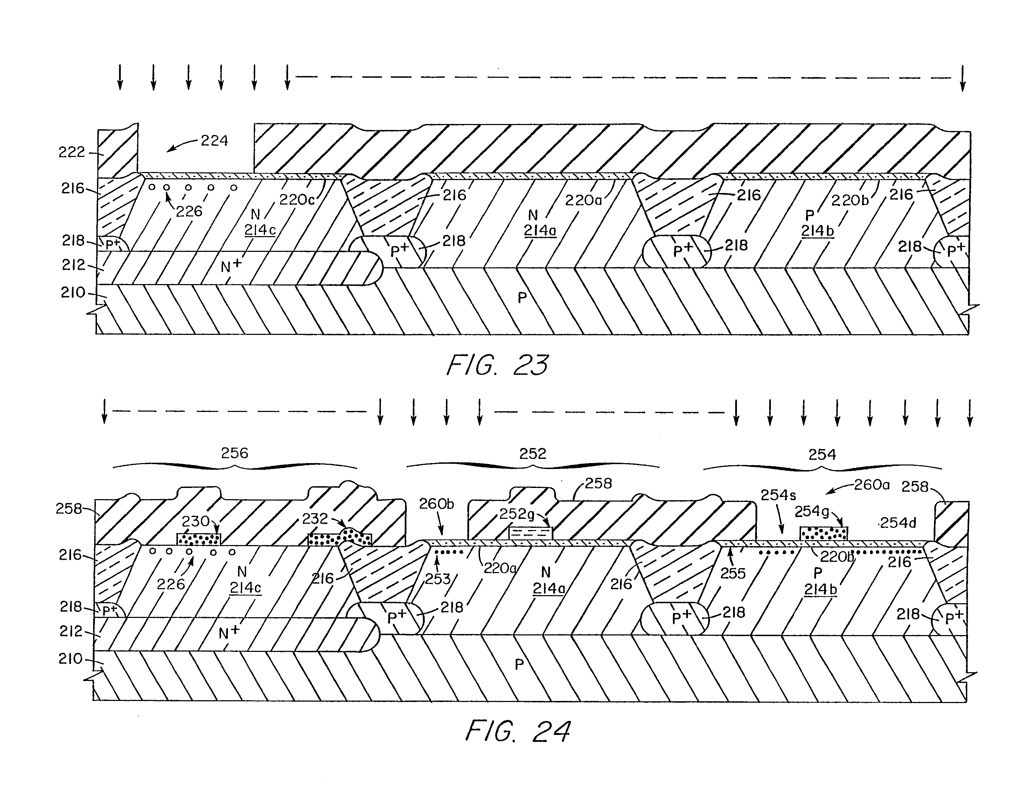

Referring now to FIG. 22, insulating regions 216 (here, $SiO_2$) and $p^+$-type conductivity silicon channel stops 218 are formed in epitaxial layer 214, here according to the process described in U.S. Patent No. 4,569,698, issued to Wolfgang M. Feist on February 11, 1986 and assigned to the present assignee. During such process, $Si_3N_4$ layer 206 and $SiO_2$ layer 202 are removed. Thus, as shown in FIG. 22, the structure comprises a plurality (three being shown) of electrically isolated regions: CMOS n-well 214a; CMOS p-well 214b; and bipolar transistor region 214c. Referring to FIG. 23, a thin layer comprising regions 220a, 220b, 220c of $SiO_2$, here between 150 Å and 250 Å and preferably 230 Å thick, is grown over epitaxial layer areas 214a, 214b, 214c, respectively (such as by heating the structure to 900°C in oxygen for 50 minutes). A layer 222 of photoresist is then deposited and patterned to form a window 224 therein. A suitable p-type conductivity dopant, here boron, is ion implanted (here at a dosage of $1 \times 10^{13}/cm^2$ at 30 Kev) through window 224 and thin $SiO_2$ layer 220c to form p-type base region 226 of about 1000 Å in depth in bipolar epitaxial layer area 214c, as previously described in connection with FIG. 2. It is noted that such dopant is prevented from entering CMOS n-well 214a or CMOS p-well 214b by photoresist layer 222. Such photoresist layer 222 then is removed and a photoresist layer (not shown) is deposited to mask $SiO_2$ layers 220a, 220b and oxide layer 220c is selectively removed from bipolar transistor region 214c, here with hydroflouric acid.

Referring now to FIG. 24 (and also to FIGS. 3 and 4 and the accompanying descriptions thereof), a layer of polysilicon, here having a thickness of about 2500 Å, is deposited over the surface of the structure. Then, as previously discussed, the portion of such polysilicon overlaying the bipolar transistor 256 and which will subsequently be patterned to form an emitter region 230 and collector contact 232 is doped with a suitable n-type dopant, such as arsenic, while the remainder of such polysilicon layer is masked by a layer of photoresist (not shown). After removal of such photoresist layer, another photoresist mask, not shown, is deposited over the polysilicon and is selectively patterned to cover only selected regions 230, 232, 252g, 254g of such polysilicon layer which will become, respectively: the emitter region of bipolar transistor 256; the collector contact of bipolar transistor 256; the gate electrode of a p-channel MOSFET 252; and the gate electrode of an n-channel MOSFET 254. The remaining portions of the polysilicon layer are then removed, here preferrably by the reactive-ion-etching method discussed above. As is known, optimum electrical characteristics for CMOS transistors 252, 254 are achieved with an n-doped polysilicon gate 254g for n-channel MOSFET 254 and a p-doped polysilicon gate 252g for p-channel MOSFET 252. Thus, photoresist layer 258 is deposited over the surface of the structure and patterned to form a first window 260a therein, exposing polysilicon gate electrode 254g, drain region 254d and source region 254s of n-channel MOSFET 254. It is noted that a portion 255 of MOSFET 254 is masked by photoresist layer 258, for purposes to be explained. Photoresist layer 258 is further provided with a second window 260b exposing a portion 253 of p-channel MOSFET 252. A suitable n-type conductivity dopant, here arsenic, is implanted through windows 260a, 260b, here at a dosage of $4 \times 10^{15}/cm^2$ at 160 Kev. Such implantation step forms n-type conductivity gate, source and drain regions 254g, 254s, 254d for n-channel MOSFET 254 (i.e., in p-well 214b) and n-type conductivity substrate (i.e. n-well) contact 253 for p-channel MOSFET 252 (i.e., in n-well 214a). Photoresist layer 258 is then removed by any conventional method.

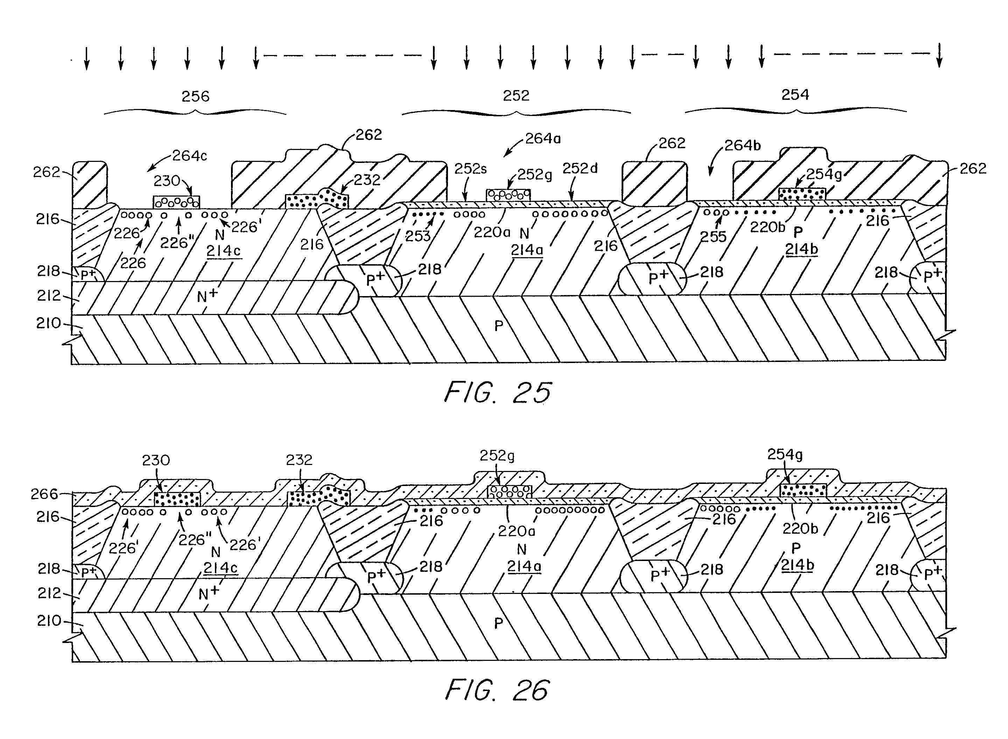

Referring to FIG. 25, a layer 262 of photoresist is deposited over the structure and patterned to form a first window 264a therein, exposing gate electrode 252g, source region 252s and drain region 252d of p-channel MOSFET 252, while masking contact region 253 thereof, as shown. Photoresist layer 262 is also patterned with a second window 264b exposing substrate (p-well) contact region 255 of n-channel MOSFET 254. Further, and referring also to FIG. 5, photoresist layer 262 is provided with a third window 264c (analogous to window 24' in photoresist layer 22' of FIG. 5) exposing base region 226. Next, silicon is here ion implanted through windows 264a, 264b, 264c in two doses of $1 \times 10^{15}/cm^2$ at 100 Kev and $6 \times 10^{14}/cm^2$ at 60 Kev, respectively, followed by ion implantation of a suitable p-type conductivity dopant (here boron in the form of $BF_2$ at a dosage of about $5 \times 10^{14}/cm^2$ at 90 Kev). It is noted that such boron dosage may be increased, such as to about $2 \times 10^{15}/cm^2$, to provide heavier doping of the exposed portions of base region 226 and source and drain regions 252s, 252d; if so, however, photoresist layer 262 should also be patterned to mask emitter region 230 to prevent excessive compensation of the arsenic dopant therein by the implanted boron. The implanted silicon amorphizes the portions of epitaxial layer 214 exposed by windows 264a, 264b, 264c, thereby preventing channeling of the implanted boron and thus reducing the p-n junction depth of MOSFETs 252, 254 and bipolar transistor 256 (which should be as shallow as possible for submicron transistors). It is noted that the implanted boron forms inactive base regions 226' in those portions of base region 226 unmasked by polysilicon emitter region 230, with the remaining portion 226'' of base region 226 masked by emitter region 230 becoming the active base region of bipolar transistor 256, as discussed above with reference to FIG. 5. Thus, it is noted that the masking step of FIG. 5 may be combined with that of FIG. 25 when fabricating bipolar and MOS transistors together (i.e., Bi-CMOS), thereby saving a masking step. Photoresist layer 262 is then removed in any conventional manner.

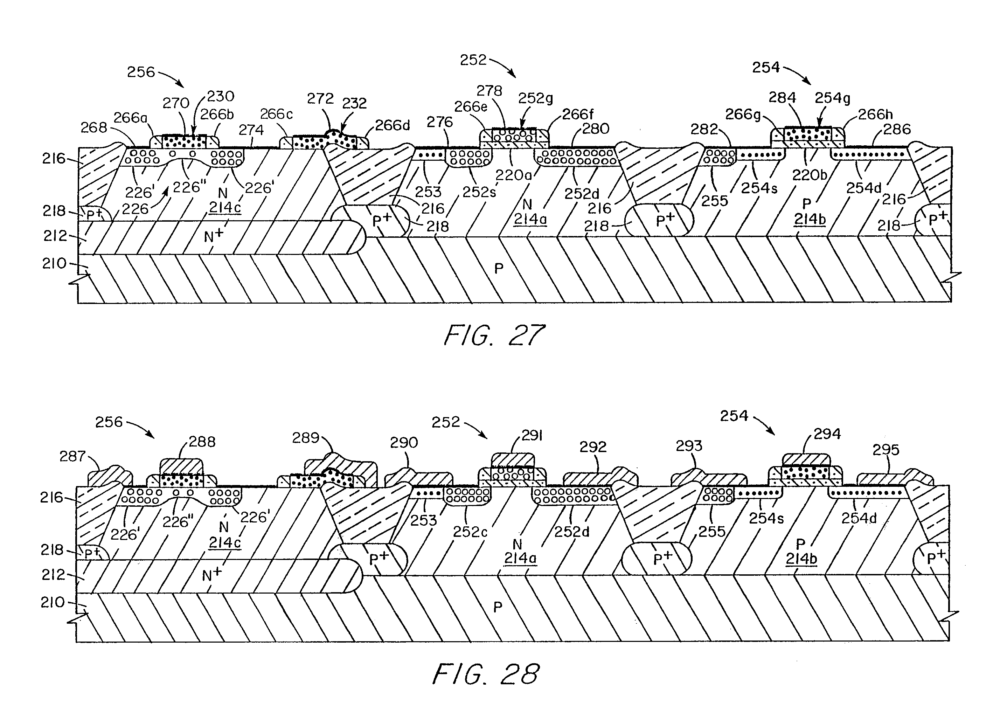

Referring now to FIG. 26, an insulating layer 266, here comprising $SiO_2$, is deposited to a thickness of between 1500 Å and 3000 Å, here to approximately 2000 Å in thickness, over the entire surface of the structure in the manner discussed above in connection with FIG. 6. Referring additionally to FIG. 27, silicon dioxide layer 266 is then anisotropically etched away from horizontal surfaces (i.e., vertically etched), here using $CHF_3$, commercially available as Freon 13®. As previously discussed, such vertical etching of $SiO_2$ layer 266 exposes the upper surfaces of emitter region 230 and collector contact 232 and also a portion of the surface of inactive base region 226', while forming insulating sidewall spacers 266a, 266b on each side of polysilicon emitter region 230 and insulating spacers 266c, 266d abutting each side of collector contact 232. Further, such etching exposes the upper surfaces of gate electrodes 252g, 254g, and portions of the surfaces of source regions 252s, 254s, and drain regions 252d, 254d, while forming insulating sidewall spacers 266e, 266f abutting each side of MOS gate electrode 252g and spacers 266g, 266h disposed abutting each side of MOS gate electrode 254g. Each insulating spacer 266a-266h has a width of between 1000 Å and 2500 Å. It is noted that the anisotropic etching also removes all portions of SiO2 layers 220a, 220b not disposed beneath gate electrodes 252g, 254g, respectively, and spacers 266e-266f, 266g-266h, respectively, (i.e. the gate oxide layers of MOS transistors 252, 254). It is further noted that at this point photoresist layer 262 of FIG. 25 may be reapplied and patterned with windows 264a, 264b, 264c to re-expose, respectively: source and drain regions 252s, 252d of MOSFET 252; contact region 255 of MOSFET 254; and the portions of inactive base region 226' not masked by emitter region 230 and spacers 266a, 266b. Then, additional p-type dopant (such as boron) may be implanted therein to increase the dopant concentrations of source, drain and contact regions 252s, 252d, 255 and inactive base region 226'. It is noted that such photoresist layer 262 masks MOS transistor 254 from such added p-type dopant implant. It is also noted that such re-applied photoresist layer 262 should be pattered to also mask emitter region 230 to prevent the added p-type dopant from excessively compensating the n-type dopant therein. Photoresist layer 262 is then conventionally removed.

The structure is then heated, here at between 900° C and 920° C for 30 minutes, to anneal out the implantation damage in epitaxial layer 214 and activate the implanted dopants in: emitter region 230; base region 226; collector contact 232; MOS gate electrodes 252g, 254g; MOS source regions 252s, 254s; MOS drain regions 252d, 254d; and MOS substrate contact regions 253, 255. Here, p-type (i.e. boron) doped regions 252s, 252d, 255 reach a depth of between approximately 2500 Å and 3000 Å, while that of n-type (i.e. arsenic) doped regions 254s, 254d, 253, is between 1500 Å and 2000 Å.

As further shown in FIG. 27, a metal layer, here comprising titanium, is deposited over the surface of the structure and the structure heated to alloy such metal with exposed silicon surfaces. As discussed, the metal does not react with SiO2 surfaces (such as surfaces of insulating spacers 266a-266h). The unreacted metal is then removed, here with hydrogen peroxide. As previously discussed and as shown in FIG. 27, self-aligned silicide contacts 268, 270, 272 remain on the surfaces of the inactive base region 226', polysilicon emitter region 230 and polysilicon collector contact 232, respectively, of bipolar transistor 256. Silicide contact 274 is disposed on the surface of epitaxial layer area 214c at the p-n junction between inactive base region 226' and collector region 214c, thereby providing a Schottky diode between the base and collector of bipolar transistor 256, as discussed. Additionally, silicide contacts 276, 278, 280 are disposed on the surfaces of source region 252s, gate electrode 252g and drain region 252d of p-channel MOSFET 252, as shown. Likewise, source region 254s, gate electrode 254g and drain region 254d of n-channel MOSFET 254 have silicide contacts 282, 284, 286, respectively, disposed thereon.

With this arrangement, the silicide contacts 268-286 are formed on as much of the surfaces of the transistors 252, 254, 256 as possible, with adjacent silicide contacts being electrically insulated from each other by insulating sidewall spacers 266a-266h. Because SiO2 spacers 266a-266h are quite narrow (here between 1000 Å and 2500 Å), the silicide contacts 268-286 are self-aligned to cover as much surface area as possible, thereby reducing the contact resistance of the respective device regions covered by such silicide contacts 268-286. For example, base silicide contact 268 covers the entire surface of inactive base region 226' except that covered by spacer 266a, thereby reducing the lateral base resistance of bipolar transistor 256. Likewise, source and drain silicide contacts 276, 280 of MOSFET 252 and source and drain silicide contacts 282, 286 of MOSFET 254 each cover substantially the entire surface of their respective device regions (i.e., source and drain regions) and terminate within between 1000 Å and 2500 Å (the width of a sidewall spacer) of respective gate electrodes 252g, 254g, thereby substantially reducing the contact resistance, source-to-gate resistance and gate-to-drain resistance of MOSFET'S 252, 254. Also, the length of such MOSFETs may be substantially reduced, as discussed above for bipolar transistor, here to about 5 μm each (approximately the same as the width of bipolar transistor 256, as discussed above in conjunction with FIG. 10). Finally, with the process of the present invention Bi-CMOS transistors may be fabricated together on the same substrate with a minimum of added masking steps.

Referring to FIG. 28, metal contacts 287, 288, 289 are applied to the base, emitter and collector silicide contacts of bipolar transistor 256 in a conventional manner as discussed above. Also applied in the same manner are source, gate, and drain metal interconnects 290, 291, 292 for MOSFET 252 and 293, 294, 295 for MOSFET 254, as shown, to complete the fabrication of CMOS transistor pair 252, 254. Metal electrode 290 should cover the p-n junction between source region 252s and contact region 253, and metal electrode 293 should likewise overlay the p-n junction between source region 254s and contact region 255, so that such p-n junctions are further ensured to be short-circuited.

Having described preferred embodiments of the present invention, modifications and alterations thereto may become apparent to those skilled in the art. Accordingly, it is intended that the scope of the present invention be limited only by the scope of the appended claims.

## Claims

1. A method of forming a bipolar transistor in a semiconductor structure comprising the steps of:

(a) forming a base region in the semiconductor structure, said base region having a first portion and a second portion disposed adjacent to the first portion;

(b) disposing an emitter region on a surface of the first portion of the base region, said emitter region having an upper surface and a first side surface;

(c) forming a layer of insulating material over a surface of the second portion of the base region, the upper surface of the emitter region and the first side surface of the emitter region; and (d) selectively removing portions of said insulating material layer to expose the upper surface of the emitter region and a portion of the surface of the second portion of the base region, and to maintain a first region of the insulating material between the exposed surface portion of the second portion of the base region and the first side surface of the emitter region.

2. The method of claim 1 wherein said step of selectively removing portions of the insulating layer comprises the step of vertically anisotropically etching said insulating layer.

3. The method of claim 1 wherein the emitter region further comprises a second side surface, and further comprising the steps of:

(a) disposing a collector contact over a surface of the semiconductor structure spaced from the base region and the second side surface of the emitter region, said collector contact having an upper surface and a side surface;

(b) forming a layer of insulating material over: the surface of the semiconductor structure between the emitter region and the collector contact; the second side surface of the emitter region; and the side upper surfaces of the collector contact; and

(c) selectively removing portions of said insulating layer to expose a portion of the surface of the semiconductor structure between the emitter region and the collector contact and the upper surface of the collector contact, and to maintain a second region of the insulating material between said exposed surface portion of the semiconductor structure and the second side surface of the emitter region and a third region of the insulating material between said exposed surface portion of the semiconductor structure and the side surface of the collector contact.

4. The method of Claim 3 wherein said step of selectively removing portions of said insulating layer comprises the step of vertically anisotropically etching said insulating layer.

5. A method of forming a bipolar transistor in a semiconductor structure having a first-type conductivity, comprising the steps of:

(a) forming a base region having a second-type conductivity, opposite the first-type conductivity, in the semiconductor structure;

(b) disposing an emitter region comprising semiconductor material having the first-type conductivity on a surface of a first portion of the base region, said emitter region having an upper surface and a first side surface;

(c) forming an active base region in the first portion of the base region and an inactive base region in a second portion of the base region adjacent the first portion thereof and the first side surface of the emitter region;

(d) forming a layer of insulating material over: a surface of the inactive base region; the first side surface of the emitter region; and the upper surface of the emitter region;

(e) selectively removing portions of said insulating material layer to expose the upper surface of the emitter region and a portion of the surface of the inactive base region, and to maintain a first region of the insulating material between the exposed portion of the surface of the inactive base region and the first side surface of the emitter region; and

(f) forming a first contact comprising metal on the exposed upper surface of the emitter region and a second contact comprising metal on the exposed portion of the surface of the inactive base region, with said first insulating material region electrically isolating said first and second contacts from each other.

6. The method of claim 5 wherein the emitter region additionally includes a second side surface, and further comprising the steps of:

(a) disposing a collector contact comprising semiconductor material having the first-type conductivity on a surface of the semiconductor structure spaced from the second side surface of the emitter region and from a third portion of the base region, the third portion of the base region being adjacent to the first portion thereof and the second side surface of the emitter region, said collector contact having an upper surface and a side surface;

(b) said insulating material layer forming step also comprising the step of forming said insulating material layer additionally over: the second side surface of the emitter region; the surfaces of the semiconductor structure and third base region portion disposed between the emitter region and the collector contact; and the side surface and upper surface of the collector contact; and

(c) said selective removal step also comprising the step of removing portions of said insulating material to expose: a portion of the surface of the semiconductor structure disposed between the emitter region and the collector contact, a portion of the surface of the third portion of the base region; and the upper surface of the collector contact, and to maintain a second region of the insulating material between the second side surface of the emitter region and said exposed surface portion of the third portion of the base region, and to maintain a third region of the insulating material between said exposed portion of the surface of the semiconductor structure disposed between the emitter region and the collector contact and the side surface of the collector contact.

7. The method of claim 6 further comprising the step of forming a fourth contact comprising metal on the exposed surface portions of the semiconductor structure and third base region portion disposed between the emitter region and the collector contact and on a junction between said third base region portion and the semiconductor structure, with the second region of the insulating material electrically isolating said fourth contact from the second contact, and the third region of the insulating material electrically isolating said fourth contact from the third contact.

8. The method of claim 7 further comprising the step of preventing said fourth contact from forming in a region of said junction between the third base region portion and the semiconductor structure.

9. The method of claim 5 wherein the active base and inactive base forming step comprises the step of masking the first portion of the base region with the emitter region and implanting particles of the second-type conductivity into the second portion of the base region unmasked by the emitter region to form the inactive base region in said second portion and the active base region in said first portion.

10. The method of claim 9 further comprising, after the selective removal step, the step of masking the active base region and a portion of the inactive base region with the emitter region and the first region of the insulating material and implanting particles of the second-type conductivity into the portion of the inactive base region exposed by said emitter region and the first region of the insulating material.

11. The method of claim 10 further comprising the step of masking the emitter region during the implantation of particles of the second-type conductivity into the portion of the inactive base region exposed by the emitter region and the first region of the insulating material.

12. A method of forming a bipolar transistor in a semiconductor structure having a first-type conductivity, comprising the steps of:

(a) forming a base region having a second-type conductivity, opposite the first-type conductivity, in the semiconductor structure;

(b) disposing a plurality of spaced emitter regions comprising semiconductor material having the first-type conductivity on a surface of the semiconductor structure over first portions of the base region, each one of said plurality of emitter regions having an upper surface and a pair of side surfaces;

(c) masking the first portions of the base region with the plurality of emitter regions and implanting particles of the second-type conductivity in second portions of the base region unmasked by the plurality of emitter regions forming a plurality of inactive base regions in said second portions and a plurality of active base regions in said first portions;

(d) forming a layer of insulating material over surfaces of the plurality of inactive base regions, the pair of side surfaces of each one of the plurality of emitter regions, and the upper surfaces of the plurality of emitter regions;

(e) selectively removing portions of said insulating material to expose the upper surfaces of the plurality of emitter regions and portions of the surfaces of the plurality of inactive base regions, and to maintain a pair of regions of insulating material abutting the pair of side surfaces of each one of the plurality of emitter regions; and

(f) forming a first plurality of contacts comprising metal on the exposed upper surfaces of the plurality of emitter regions and a second plurality of contacts comprising metal on the exposed portions of the surfaces of the plurality of inactive base regions, with each one of the of insulating material regions electrically isolating adjacent ones of the first and second plurality of contacts from each other.

13. The method of claim 12 further comprising the step of disposing a collector contact comprising semiconductor material having the first-type conductivity on a surface of the semiconductor layer spaced from the base region and the plurality of emitter regions.

14. The method of claim 12 further comprising, after the selective removal step, the step of:

masking the plurality of active base regions and adjacent portions of the plurality of inactive base regions with the plurality of emitter regions and the pairs of insulating material regions disposed abutting the pairs of side surfaces thereof, and implanting particles of the second-type conductivity into the portions of the plurality of inactive base regions unmasked by the plurality of emitter regions and pairs of insulating material regions.

15. The method of claim 14 further comprising the steps of masking the plurality of emitter regions during the implantation of particles of the second-type conductivity into the portions of the plurality of inactive base regions unmasked by the plurality of emitter regions and pairs of insulating material regions.

16. A method of forming a bipolar transistor and a pair of complementary field effect transistors in a semiconductor structure having a first-type conductivity and a first dopant concentration, comprising the steps of:

(a) forming a first well of the first-type conductivity and a second dopant concentration in a first region of the semiconductor structure and a second well having a second-type conductivity, opposite the first-type conductivity, in a second region of the semiconductor structure;

(b) forming a base region having the second-type conductivity for the bipolar transistor in a third region of the semiconductor structure, said base region comprising a first portion and a second portion disposed adjacent to the first portion;

(c) disposing an emitter region on a surface of the first portion of the base region, a first gate electrode over a first portion of the first well and a second gate electrode over a first portion of the second well, the emitter region and the first and second gate regions each comprising an upper surface and first and second side surfaces;

(d) implanting particles having the first-type conductivity into: the second gate electrode; a second portion of the second well adjacent the first portion thereof and the first side surface of the second gate electrode to form a second source region therein; and, a third portion of the second well adjacent the first portion thereof and the second side surface of the second gate electrode to form a second drain region therein;

(e) implanting particles having the second-type conductivity into: the second portion of the base region to form an inactive base region in said second portion of the base region and an active base region in said first portion of the base region; the first gate electrode; a second portion of the first well adjacent the first portion thereof and the first side surface of the first gate electrode to form a first source region therein; and a third portion of the first well adjacent the first portion thereof and the second side surface of the first gate electrode to form a first drain region therein;

(f) forming a layer of insulating material over the structure;

(g) selectively removing portions of said insulating material layer to expose portions of the surfaces of the inactive base region, the first source and drain regions, the second source and drain regions and the upper surfaces of the emitter region and first and second gate electrodes, and to maintain:

1. a first region of the insulating material between the exposed portion of the surface of the inactive base region and the first side surface of the emitter region;

2. a second region of the insulating material disposed between the exposed surface portion of the first source region and the first side surface of the first gate electrode;

3. a third region of the insulating material disposed between the exposed portion of the surface of the first drain region and the second side surface of the first gate electrode;

4. a fourth region of the insulating material disposed between the exposed portion of the surface of the second source region and the first side surface of the second gate electrode; and

5. a fifth region of the insulating material disposed between the exposed portion of the surface of the second drain region and the second side surface of the second gate electrode; and

(h) forming contacts comprising metal on the exposed portions of the surfaces of the inactive base region, the first source and drain regions, the second source and drain regions, and the exposed upper surfaces of the emitter region and first and second gate electrodes.

17. The method of claim 16 further comprising the steps of:

(a) disposing a collector contact comprising semiconductor material having the first-type conductivity on a surface of the third region of the semiconductor structure spaced from the second side surface of the emitter region and from a third portion of the base region prior to the insulating material layer forming step, the third portion of the base region being adjacent to the first portion thereof and the second side surface of the emitter region, said collector contact having an upper surface and a side surface; and

(b) said selective removal step also comprising the step of removing portions of said insulating material to expose the upper surface of the collector contact and a portion of the surface of the third region of the semiconductor structure and third base region portion disposed between the emitter region and the collector contact, and to maintain a sixth region of the insulating material between the second side surface of the emitter region and said exposed surface portion of the third portion of the base region, and to maintain a seventh region of the insulating material between said exposed portion of the surface of the third region of the semiconductor structure and the side surface of the collector contact.

18. The method of claim 16 further comprising the steps of:

(a) implanting particles having the first-type conductivity into a portion of the first source region spaced from the first side surface of the first gate electrode, the first-type conductivity particles forming a junction with the second-type conductivity particles in the first source region; and

(b) forming a contact comprising metal over said junction in the first source region.

19. The method of claim 16 further comprising the steps of:

(a) implanting particles having the second-type conductivity into a portion of the second source region spaced from the first side surface of the second gate electrode, the second-type conductivity particles forming a junction with the first-type conductivity particles in the second source region; and

(b) forming a contact comprising metal over said junction in the second source region.

20. The method of claim 16 wherein the first well and second well forming step comprises the steps of:

(a) implanting particles having the first conductivity type in the first region of the semiconductor structure;

(b) implanting particles having the second conductivity type in the second region of the semiconductor structure; and

(c) substantially simultaneously driving the first conductivity type particles to a first predetermined depth in the semiconductor structure to form the first well and the second conductivity type particles to a second predetermined depth to form the second well.

21. The method of claim 20 wherein said driving step comprises

(a) applying a layer comprising silicon nitride to a predetermined thickness over the first and second regions of the semiconductor structure; and

(b) heating the structure at a predetermined temperature for a predetermined time to substantially simultaneously drive the first- and second-type conductivity particles to the first and second predetermined depths, respectively.

22. A method of forming a plurality of doped regions in a semiconductor structure comprising the steps of:

(a) implanting particles having a first-type conductivity in a first region of the semiconductor structure;

(b) implanting particles having a second-type conductivity, opposite to the first-type conductivity, in a second region of the semiconductor structure;

(c) depositing a layer comprising silicon nitride over the first and second regions of the semiconductor structure; and

(d) heating the semiconductor structure at a predetermined temperature for a predetermined time selected to drive the first-type conductivity particles to a first predetermined depth in the first region and the second-type conductivity particles to a second predetermined depth in the second region.

23. The method of claim 22 further comprising the steps of forming an insulating layer over the semiconductor structure, implanting said first- and second-type conductivity particles through the insulating layer into the first and second regions, respectively, and depositing the silicon nitride layer over said insulating layer.

24. The method of claim 22 wherein said heating step comprises the steps of:

(a) heating the semiconductor structure at a first predetermined temperature for a first predetermined time; and

(b) heating the structure at a second predetermined temperature for second predetermined time longer than the first predetermined time.

25. The method of claim 24 wherein the first predetermined temperature is in the range of 800°C to 1200°C and the first predetermined time is less than one hour, and the second predetermined temperature is between 900°C and 1200°C and the second predetermined time is greater than one hour.

26. A method of forming a plurality of doped regions in a semiconductor structure, comprising the steps of:

(a) implanting particles having a first-type conductivity in a first region of the semiconductor structure;

(b) implanting particles having a second-type conductivity, opposite the first-type conductivity, in a second region of the semiconductor structure;

(c) depositing a layer of material over the first and second regions of semiconductor structure; and

(d) heating the semiconductor structure to drive the first-type conductivity particles to a first predetermined depth in the first region and the second-type conductivity particles to a second predetermined depth in the second region, said layer of material being selected to substantially prevent said first- and second-type conductivity particles from evaporating from the first and second regions, respectively, and re-depositing in a third region of the semiconductor structure during said heating step.

0290268

FIG. 1

FIG. 2

FIG. 3

FIG. 4

FIG. 5

FIG. 6

FIG. 7

FIG. 8

FIG. 9

FIG. 10

FIG. 11

FIG. 12

FIG. 13

0290268

FIG. 14

FIG. 15

FIG. 16

0290268

FIG. 17

FIG. 18

0290268

FIG. 19

204a
202
214
212
210

205a

N
214a

N
214b

P

N
214c

N+

FIG. 20

204b
202
214
212
210

205b

N
214a

N
214b

P

N
214c

N+

FIG. 21

FIG. 22

FIG. 23

FIG. 24

FIG. 25

FIG. 26

0290268

FIG. 27

FIG. 28